# FASCICULE DE BREVET EUROPEEN

(11) **EP 2 827 390 B1**
(45) Date de publication et mention de la délivrance du brevet: **17.10.2018**
(21) Numéro de dépôt: 14176653.5
(22) Date de dépôt: 11.07.2014
(51) Int. Cl.: H01L 33/38, H01L 33/14

(54) **Structure émissive à injection latérale de porteurs**
Emissionsstruktur mit seitlicher Einspritzung von Trägerstoffen
Emissive structure with lateral injection of carriers

(30) Priorité: 15.07.2013 FR 1356948
(43) Date de publication de la demande: 21.01.2015
(73) Titulaire: COMMISSARIAT À L'ÉNERGIE ATOMIQUE ET AUX ÉNERGIES ALTERNATIVES, 75015 Paris (FR)
(72) Inventeur: Vaufrey, David, 38000 Grenoble (FR)
(74) Mandataire: Novaimo

(56) Documents cités:
- EP-A1- 2 315 273
- EP-A2- 2 330 643

## Description

### Domaine technique de l'invention

L'invention concerne le domaine des diodes électroluminescentes, de préférence à base de matériau lll-V ou II-VI, et plus particulièrement des électrodes d'alimentation d'une diode.

L'invention a pour objet plus particulièrement une structure comme définie dans les revendications attenantes, destinée à émettre un rayonnement électromagnétique, comportant des première et deuxième électrodes configurées de sorte à permettre l'injection de porteurs dans au moins un empilement à base de semi-conducteurs en vue de leurs recombinaisons dans une zone active de l'empilement pour former tout ou partie du rayonnement électromagnétique à émettre. La première électrode présente au moins une première face d'injection de porteurs dans l'empilement orientée dans une direction différente de la direction dans laquelle l'empilement est formé et la deuxième électrode comporte une deuxième face d'injection de porteurs dans l'empilement.

### État de la technique

Une diode électroluminescente est généralement composée d'un empilement d'au moins deux matériaux semi-conducteurs de type de conductivité opposée et insérés entre deux électrodes. Lorsqu'une tension est appliquée entre les deux électrodes, des porteurs sont injectés via lesdites électrodes dans l'empilement de semi-conducteurs, puis sont transportés dans les semi-conducteurs. Des électrons sont injectés depuis la cathode, alors que des trous sont injectés depuis l'anode. Des paires électron-trou peuvent se former dans une zone active de l'empilement, et peuvent éventuellement aboutir à des excitons, qui peuvent éventuellement se désexciter de manière radiative. Les photons générés peuvent éventuellement s'échapper de l'empilement de semi-conducteurs si, à minima, l'une des électrodes est transparente ou semi-transparente, ou l'une des électrodes ne recouvrent pas complètement une face de la diode électroluminescente, ou encore une combinaison des deux possibilités évoquées ci-avant.

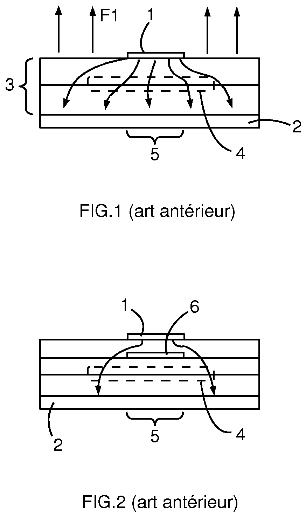

La figure 1 illustre une diode électroluminescente conventionnelle comprenant une première électrode 1 et une deuxième électrode 2 entre lesquelles est interposé un empilement 3 comprenant une zone active 4 (dont une partie représentée en pointillés est traversée par un courant). La première électrode 1 ne recouvre qu'une partie de la surface supérieure de l'empilement de sorte à permettre l'émission de photons selon les flèches F1. La densité de courant dans une telle diode électroluminescente est maximale entre les deux électrodes 1 et 2 dans un volume 5 dit « ombré » du fait du recouvrement d'une portion de la deuxième électrode 2 par la première électrode 1. Il en résulte que la plupart des recombinaisons de porteurs sont faites au niveau de ce volume 5 alors que la première électrode 1 dégrade ensuite l'émission des photons obtenus selon F1 du fait de sa faible transparence, ou non-transparence.

Pour s'affranchir de cette problématique, il a été proposé d'introduire une couche de propagation (« spreading layer » en langue anglaise) entre la première électrode 1 et la zone active 4. La couche de propagation se caractérise par une conductivité élevée permettant au courant de diverger plus largement afin de permettre l'obtention d'une zone active couvrant une surface plus importante. Ceci permet d'améliorer l'efficacité de la diode électroluminescente en termes d'émission de photons.

Une autre solution illustrée à la figure 2 a été de disposer une couche de blocage 6 entre la première électrode 1 et la zone active 4 au niveau du volume 5 « ombré » situé entre la première électrode 1 et la deuxième électrode 2.

La couche de blocage 6 est définie par la formation d'une barrière énergétique limitant le passage d'au moins un type de porteur. La hauteur de barrière pour les électrons (trous) est égale à la différence entre les niveaux de valence (conduction) de la couche de propagation et de la couche de blocage. La présence de la couche de blocage structurée impose au courant de la contourner. La zone active est alors traversée par un courant dans une région d'émission annulaire centrée sur la verticale de la deuxième électrode 2 hors de la zone de recouvrement avec la première électrode 1. Cette solution présente l'avantage que le courant ne circule pas dans la partie de couche active appartenant au volume ombrée par la première électrode 1.

Cependant, le blocage s'estompe au fur et à mesure que la tension appliquée entre les électrodes augmente, si bien que pour des tensions élevées, le courant se comporte comme si la couche de blocage n'était pas présente. De plus, l'introduction de la couche de blocage structurée requiert une interruption de l'épitaxie de l'empilement pour procéder à une gravure suite à une photolithographie. Cette interruption est coûteuse en temps, en équipement, en matériaux et donc en argent.

Encore une autre solution est décrite dans la demande de brevet EP2341557. Cette solution nécessite l'utilisation de matériaux aptes à être dopés par implantation pour être rentable (c'est-à-dire ne pas multiplier les étapes de lithographie, de gravure et de reprise d'épitaxies). Ainsi, il existe donc un besoin d'améliorer les diodes électroluminescentes actuelles pour en exacerber l'efficacité d'émission, et de préférence tout en restant dans des situations convenables en termes de mise en oeuvre technologique.

Le document EP2315273 décrit une structure de diode électroluminescente dont une électrode possède une face d'injection de porteurs latérale, la diode possédant aussi une couche diélectrique en contact avec cette électrode.

Le document EP2330643 décrit une structure comportant deux électrodes opposées dont l'une des électrodes présente une portion qui n'est pas en regard de l'autre des électrodes.

### Objet de l'invention

Le but de la présente invention est de proposer une solution permettant notamment d'améliorer l'émission d'un rayonnement électromagnétique d'une structure.

On tend vers ce but notamment en ce que ladite deuxième face d'injection, notamment incluse dans un plan, comporte une première portion en regard de la première électrode et une deuxième portion pour laquelle la première électrode n'est pas en regard, et en ce qu'un élément diélectrique, en contact avec la première électrode, est interposé entre au moins une partie de la première électrode et au moins une partie de la première portion.

De préférence, l'empilement comporte un premier élément semi-conducteur présentant un premier dopage, notamment de type n, et un deuxième élément semi-conducteur présentant un deuxième dopage de conductivité opposée au premier dopage, et la première face d'injection est configurée de sorte à injecter des porteurs d'un premier type dans le premier élément semi-conducteur, et la deuxième électrode est configurée de sorte à injecter des porteurs d'un second type dans le deuxième élément semi-conducteur.

Selon une mise en oeuvre particulière, l'élément diélectrique est en contact avec :
- la première électrode et le premier élément semi-conducteur, ou
- la première électrode, le premier élément semi-conducteur et le deuxième élément semi-conducteur, ou
- la première électrode, le premier élément semi-conducteur, le deuxième élément semi-conducteur et la deuxième électrode.

Avantageusement, au moins une portion de la première électrode s'étendant à partir de l'élément diélectrique dans une direction opposée à la deuxième électrode est entourée par, et est en contact avec, le premier élément semi-conducteur.

Selon une mise en oeuvre particulière, la structure comporte au moins deux empilements distincts s'étendant de la deuxième électrode, et :
- l'élément diélectrique s'étend de la deuxième électrode entre les empilements, et est en contact avec une partie, délimitée au moins par les premier et deuxième éléments semi-conducteurs, d'une paroi latérale de chacun des empilements,
- la première électrode s'étend de l'élément diélectrique au moins en partie entre les deux empilements, ladite première électrode étant en contact avec une autre partie, délimitée par le premier élément semi-conducteur, de la paroi latérale de chacun des empilements.

Selon une réalisation, la première électrode comporte au moins deux faces additionnelles d'injection de porteurs dans l'empilement chacune incluses dans les plans décalés et sensiblement parallèles au plan incluant la deuxième électrode, de préférence une des faces additionnelles est en contact avec une extrémité de l'empilement opposée à la deuxième électrode, et est relié à l'autre face additionnelle par l'intermédiaire de la première face d'injection.

L'invention est aussi relative à un dispositif émissif, notamment pour affichage ou pour éclairage, comprenant au moins une structure telle que décrite ci-dessus.

L'invention est aussi relative à un procédé de fabrication d'une structure telle que décrite, un tel procédé de fabrication comporte une étape de formation, notamment par croissance, de l'empilement et une étape de formation, notamment par dépôt, de la première électrode.

Le procédé comporte une étape de formation de la deuxième électrode de telle sorte qu'elle comporte une deuxième face d'injection de porteurs dans l'empilement, ladite deuxième face d'injection, notamment incluse dans un plan, comportant une première portion en regard de la première électrode et une deuxième portion pour laquelle la première électrode n'est pas en regard, et un élément diélectrique, notamment en contact avec la première électrode, est interposé entre au moins une partie de la première électrode et au moins une partie de la première portion.

Préférentiellement, l'étape de formation de l'empilement comporte la formation d'un premier élément semi-conducteur et d'un deuxième élément semi-conducteur destiné à être interposé entre le premier élément semi-conducteur et la deuxième électrode.

Selon une mise en oeuvre particulière, le procédé comporte une étape de gravure d'au moins le premier élément semi-conducteur en direction du deuxième élément semi-conducteur et il comporte une étape de formation, notamment par dépôt, de l'élément diélectrique dans au moins une partie de l'ouverture créée par l'étape de gravure, l'étape de formation de la première électrode étant réalisée par formation de ladite première électrode sur l'élément diélectrique, ladite première électrode occupant au moins une partie du reste de l'ouverture.

Selon une réalisation, le procédé comporte les étapes suivantes :
- la formation d'au moins deux empilements distincts chacun muni d'un premier élément semi-conducteur et d'un deuxième élément semi-conducteur, notamment à partir d'un substrat de support de cristallographie adaptée à la formation par croissance des empilements,
- la formation de l'élément diélectrique dans un espace libre séparant les empilements, notamment par dépôt conforme dudit élément diélectrique,
- la formation de la première électrode de sorte à ce qu'elle soit en contact avec l'élément diélectrique et avec une partie de la paroi latérale des empilements formée par les premiers éléments semi-conducteurs desdits empilements.

### Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :
- la figure 1 est une vue latérale d'une diode électroluminescente selon l'art antérieur,
- la figure 2 est une vue d'une autre diode électroluminescente selon l'art antérieur,
- la figure 3 est une vue d'une structure selon un exemple ne faisant pas partie de l'invention,
- la figure 4 est une vue en perspective d'une variante de la figure 3,
- la figure 5 est une vue d'une structure selon une autre réalisation de l'invention,
- la figure 6 est une vue d'une variante de la figure 5,
- les figures 7 à 9 sont des vues en coupes alternatives selon le plan de coupe Pc de la figure 6,
- la figure 10 représente un mode particulier de mise en oeuvre de la structure à plusieurs empilements,
- la figure 11 illustre une variante de la figure 10,
- la figure 12 illustre une vue en coupe une adaptation particulière d'une première électrode de la structure,
- les figures 13 et 14 illustrent des variantes de formes de la première électrode de la structure,
- les figures 15 à 17 illustrent, vues en coupe, différentes étapes du procédé de fabrication de la structure,
- la figure 18 illustre une vue d'une étape particulière du procédé de fabrication de la structure.

### Description de modes préférentiels de l'invention

La structure décrite ci-après est caractérisée en ce qu'une électrode, notamment d'injection d'électrons présente au moins une face d'injection de porteurs (d'électrons dans l'exemple) disposée latéralement par rapport à la direction d'un empilement à base de semi-conducteurs.

Pour les besoins de la présente description, un empilement peut être défini comme ayant deux extrémités d'empilement opposées selon la direction dans laquelle l'empilement est formé. Par ailleurs, ces deux extrémités d'empilement sont reliées par une paroi latérale. Notamment le périmètre de chaque extrémité d'empilement forme l'interface reliant ladite extrémité d'empilement à la paroi latérale. La paroi latérale peut comporter un ou plusieurs pans.

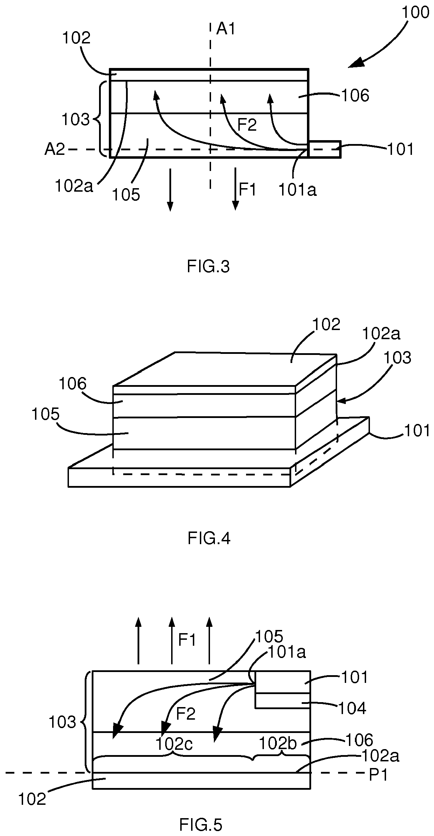

Comme illustré à la figure 3, une structure 100 destinée à émettre un rayonnement électromagnétique comporte des première 101 et deuxième 102 électrodes configurées de sorte à permettre l'injection de porteurs dans au moins un empilement 103 à base de semi-conducteurs en vue de leurs recombinaisons dans une zone active de l'empilement 103 pour former tout ou partie du rayonnement électromagnétique à émettre (de préférence selon les flèches F1).

Les première et deuxième électrodes peuvent être formées, ou constituées par tous matériaux aptes à injecter des porteurs dans l'empilement de la diode électroluminescente. Dans le cas d'une diode électroluminescente à base de GaN, la cathode sera de préférence en titane, et l'anode en palladium (ou nickel).

Par ailleurs, la première électrode 101 présente au moins une première face d'injection 101a de porteurs dans l'empilement 103 orientée dans une direction différente de la direction dans laquelle l'empilement est formé. Autrement dit, la normale de la première face d'injection 101a, en tout point de la première face d'injection 101a, forme un angle, de préférence sensiblement perpendiculaire à la direction dans laquelle l'empilement est formé. On comprend alors qu'une telle injection de porteur latérale par rapport à la direction dans laquelle l'empilement est formé va permette de favoriser la distribution (flèches F2) du courant dans l'empilement dans des zones où il n'y a pas de recouvrement entre la première électrode 101 et la deuxième électrode 102.

Avantageusement, la première face d'injection est incluse dans un plan sensiblement perpendiculaire au plan incluant l'une des extrémités d'empilement. De préférence, les deux extrémités d'empilement sont respectivement incluses dans des premier et deuxième plans parallèles et la première face d'injection est incluse dans un troisième plan sensiblement perpendiculaire aux premier et deuxième plans.

De manière générale, la face de l'empilement opposée à la deuxième électrode, formant une extrémité d'empilement, est aussi appelée face d'émission de l'empilement. On comprend alors que le rayonnement électromagnétique s'échappe de l'empilement par cette face d'émission. Autrement dit, la structure présente une face d'émission du rayonnement électromagnétique, opposée à la deuxième électrode, ladite face d'émission comportant une zone d'ombrage délimitée par la première électrode. On comprend alors que la première électrode est avantageusement disposée au niveau de cette face d'émission.

Sur l'exemple particulier de la figure 3, la première électrode est en contact avec l'empilement uniquement au niveau de la paroi latérale de l'empilement 103. Autrement dit, il n'y a aucun recouvrement de la face d'émission par la première électrode 101. Il en résulte qu'une telle structure pourra émettre plus de photons puisque la face d'émission de cette dernière ne sera pas du tout ombrée. Toujours sur la figure 3, la direction de l'empilement 103 est définie selon l'axe A1 le long duquel s'échelonne différents éléments (ou couches) semi-conducteurs, et la direction vers laquelle la première face d'injection est orientée est selon l'axe A2. Les axes A1 et A2 sont ici avantageusement sensiblement perpendiculaires l'un par rapport à l'autre.

Selon une variante, la première électrode 101 peut comporter une pluralité de premières faces d'injection orientées selon la même loi (orientée dans une direction différente de la direction dans laquelle l'empilement est formé). La figure 4 illustre une telle réalisation dans le sens où la première électrode 101 entoure tout ou partie de l'empilement 103. Ainsi, à la figure 4, la première électrode 101 forme une couronne dont toute la surface de la paroi intérieure est agencée de sorte à permettre l'injection de porteurs dans l'empilement 103.

Selon une mise en oeuvre particulière, illustrée à la figure 5, la deuxième électrode 102 comporte une deuxième face d'injection 102a de porteurs dans l'empilement 103. La deuxième face d'injection 102a est notamment incluse dans un plan P1 (le plan P1 étant dans l'exemple particulier perpendiculaire au plan de la figure 5). La deuxième face d'injection 102a comporte une première portion 102b en regard de la première électrode 101 et une deuxième portion 102c pour laquelle la première électrode 101 n'est pas en regard. On comprend que si on veut obtenir une structure optimisant l'émission de photons (notamment selon les flèches F1, c'est-à-dire par la face d'émission de la structure délimitée par l'extrémité d'empilement opposée à la deuxième électrode 102), la deuxième portion 102c de la deuxième face d'injection 102a présente une surface supérieure à celle associée à la première portion 102b de la deuxième face d'injection 102a. Le rapport de la surface de la première portion 102b sur la surface de la deuxième portion 102c peut être de ½ jusqu'à 1/100. Par ailleurs, un élément diélectrique 104, de préférence en contact avec la première électrode 101, est interposé entre au moins une partie de la première électrode 101 et au moins une partie de la première portion 102b. On comprend de cette dernière formulation que seule une partie, ou toutes les parties, (notamment incluse(s) dans des plans sensiblement parallèles au plan de la deuxième électrode) de la première électrode orientée vers la deuxième électrode peuvent être en contact avec l'élément diélectrique 104. Le rôle de cet élément diélectrique 104 est d'empêcher un cheminement le plus court du courant dans une zone de mise en regard des première et deuxième électrodes 101, 102 qui aurait pour conséquence de favoriser une recombinaison des porteurs dans une zone de l'empilement ne permettant pas une restitution correcte du rayonnement électromagnétique associé auxdites recombinaisons.

Par ailleurs, il résulte préférentiellement du contact entre l'élément diélectrique 104 et la première électrode 101 que l'injection de porteurs via la première électrode 101 se fait par une partie latérale de la première électrode formée au dessus de l'élément diélectrique 104. Cette partie latérale est alors formée par la première face d'injection 101a.

Par « la deuxième face d'injection 102a comporte une première portion 102b en regard de la première électrode 101 et une deuxième portion 102c pour laquelle la première électrode 101 n'est pas en regard », on entend respectivement qu'une droite normale à la première portion 102b de la deuxième surface d'injection 102 passe par la première électrode 101 en tout point de la première portion 102b, et qu'une droite normale à la deuxième portion 102b de la deuxième surface d'injection 102 ne passe pas par la première électrode 101 et ce en tout point de la deuxième portion 102b.

De manière plus générale, dans la présente description on entend par A est en regard de B que la droite normale à A, en tout point délimité par A, passe par B. A et B pouvant être tout type d'élément mais préférentiellement A est une face avantageusement plane.

Plus particulièrement, l'introduction de l'élément diélectrique 104 interdit le passage direct et vertical des porteurs de la première électrode 101 à la deuxième électrode 102. Au contraire, les porteurs sont contraints d'avoir une trajectoire courbée, comme symbolisée par les flèches courbées F2 de la figure 5, et de se disperser dans l'empilement 103 pour traverser la zone active dans une zone non en regard avec la première électrode 101. Ainsi, le courant injecté dans la structure via les première et deuxième électrodes 101, 102 traverse la zone active préférentiellement que dans les zones ou les photons émis pourront s'échapper de la structure. Dans cette configuration, le courant ne traverse pas, ou peu, la zone active dans la partie de l'empilement 103 interposée entre l'élément diélectrique 104 et la deuxième électrode 102.

De manière générale, l'élément diélectrique peut être formé en Silice, en nitrure de silicium, en oxy-nitrure, ou encore être un multicouche de ces matériaux. Avantageusement, le, ou les, matériaux utilisés sont aptes à passiver la paroi latérale de l'empilement 103. Ainsi, la formation de l'élément diélectrique pourra s'accompagner d'un dépôt concomitant du même matériau sur la paroi latérale de l'empilement 103.

On comprend de la figure 5, que toute ou partie de la première électrode est encastrée dans l'empilement.

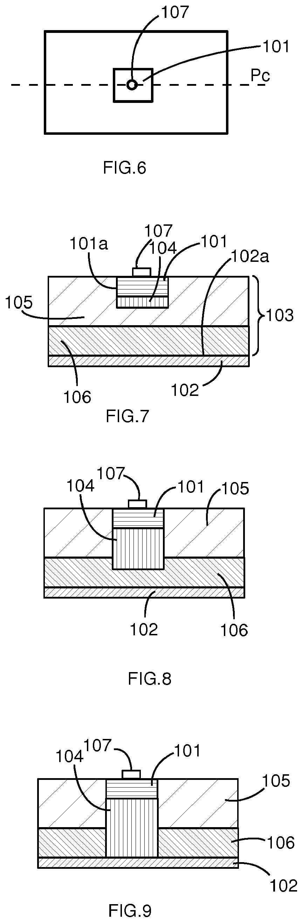

Selon une alternative à la figure 5 où la première électrode 101 est encastrée dans l'empilement 103 au niveau d'un bord de l'empilement 101, les figures 6 et 7 illustrent une variante où la première électrode 101 est encastrée dans l'empilement au niveau d'une zone centrale de la face d'émission de la structure. L'élément diélectrique 104 se retrouve alors entièrement recouvert, d'une part, par l'empilement et, d'autre part, par la première électrode 101.

Comme illustré aux figures 3, 4, 5 et 7, de manière générale, l'empilement 103 peut comporter un premier élément semi-conducteur 105 présentant un premier dopage et un deuxième élément semi-conducteur 106 présentant un deuxième dopage de conductivité opposée au premier dopage. Dans ce cas, la première face d'injection 101a est configurée de sorte à injecter des porteurs d'un premier type dans le premier élément semi-conducteur 105, et la deuxième électrode 102 est configurée de sorte à injecter des porteurs d'un second type dans le deuxième élément semi-conducteur 106 (notamment via la deuxième face d'injection 102a de la deuxième électrode 102). Par conductivité opposée, on entend une conductivité électrique, le premier élément semi-conducteur 105 étant avantageusement dopé n, et le deuxième élément semi-conducteur 106 étant avantageusement dopé p.

Le premier élément semi-conducteur 105 est préférentiellement dopé n car avec un tel dopage les porteurs injectés peuvent s'étaler plus facilement que dans le cadre d'un dopage de type p (à titre d'exemple, résistivité de l'ordre de 1 Ω.cm pour le GaN dopé p et d'environ 10⁻³ Ω.cm pour le GaN dopé n).

L'empilement peut comporter des matériaux de type lll-V ou II-VI. Ainsi, le premier élément semi-conducteur 105 peut être formé, ou constitué, par au moins l'un des matériaux suivants : GaN, ZnO, InSb, GaAs, InP, etc. agencé(s) sous forme d'une couche d'épaisseur de préférence comprise entre 150nm et 10µm. Par ailleurs, le deuxième élément semi-conducteur 106 peut être formé, ou constitué, par au moins l'un des matériaux suivants : GaN, ZnO, InSb, GaAs, InP, etc. agencé(s) sous forme d'une couche d'épaisseur de préférence comprise entre 150nm et 10µm. La zone active peut être formée par la jonction entre le premier élément semi-conducteur 105 et le deuxième élément semi-conducteur 106 agencés alors directement en contact. Cette jonction peut être une homojonction ou une hétérojonction.

Un ou plusieurs éléments semi-conducteurs additionnels peuvent être intercalés entre le premier élément semi-conducteur et le deuxième élément semi-conducteur (non représenté). Il est, par exemple, possible d'intercaler un élément actif entre les premier et deuxième éléments semi-conducteurs. Cet élément actif peut être un semi-conducteur intrinsèque ou non intentionnellement dopé dont le gap est adapté pour émettre des photons à la longueur d'onde souhaitée. Alternativement, cet élément actif peut être un système de puits quantiques (ex : double hétérojonction à puits quantiques).

Les premier et deuxième éléments semi-conducteurs, et le ou les éventuels éléments semi-conducteurs additionnels, peuvent se présenter chacun sous la forme d'une couche de l'empilement.

De préférence, l'élément diélectrique 104 est disposé de sorte à séparer la première électrode 101 de la face du premier élément semi-conducteur orientée vers la deuxième électrode d'une distance supérieure à 500nm, et de préférence supérieure à 1µm et avantageusement inférieure à 25µm. Ceci permet une distribution du courant sur de plus longues distances.

Comme illustré aux figures 5 et 7, l'élément diélectrique 104 est avantageusement en contact avec la première électrode 101 et le premier élément semi-conducteur 105. Dans cette réalisation l'élément diélectrique 104 n'est pas en contact avec le deuxième élément semi-conducteur 106 (mais avantageusement, une partie du premier élément semi-conducteur 105 est interposée entre l'élément diélectrique 104 et le deuxième élément semi-conducteur 106).

Alternativement et applicable aux différents modes de réalisation, l'élément diélectrique 104 peut, comme à la figure 8, être en contact avec la première électrode 101, le premier élément semi-conducteur 105, et le deuxième élément semi-conducteur 106. Sur l'exemple de la figure 8, il reste une partie du deuxième élément semi-conducteur 106 interposée entre l'élément diélectrique 104 et la deuxième électrode 102. Comme la zone active se trouve généralement entre le premier élément semi-conducteur 105 et le deuxième élément semi-conducteur 106 (ou est formée par leurs contacts), cette réalisation inhibe la recombinaison des porteurs dans une zone ne permettant pas leur extraction.

Selon une autre alternative applicable aux différents modes de réalisation, l'élément diélectrique 104 peut, comme à la figure 9, être en contact avec la première électrode 101, le premier élément semi-conducteur 105, le deuxième élément semi-conducteur 106 et la deuxième électrode 102. Selon cette alternative, on est sûr qu'il n'y aura aucune recombinaison dans une zone de l'empilement 103 située au-dessous de la première électrode 101.

Selon une mise en oeuvre particulière, illustrée aux figures 6 à 9 applicable à toutes les réalisations décrites en combinaison avec la présence de l'élément diélectrique 104 une face de la première électrode 101, opposée à une face de contact, ou en regard, de la première électrode 101 avec l'élément diélectrique 104, comporte un plot de connexion 107 destiné à coopérer avec un élément d'apport d'alimentation en courant de la structure.

On comprend de ce qui a été dit précédemment et notamment des réalisations des figures 6 à 9 qu'au moins une portion de la première électrode 101 s'étendant à partir de l'élément diélectrique 104 dans une direction opposée à la deuxième électrode 102 est entourée par, et est en contact avec, le premier élément semi-conducteur 105. Le fait d'entourer la première électrode 101 permet d'augmenter les surfaces de contact permettant l'injection de porteurs dans l'empilement 103 et plus particulièrement dans le premier élément semi-conducteur 105 de l'empilement 103.

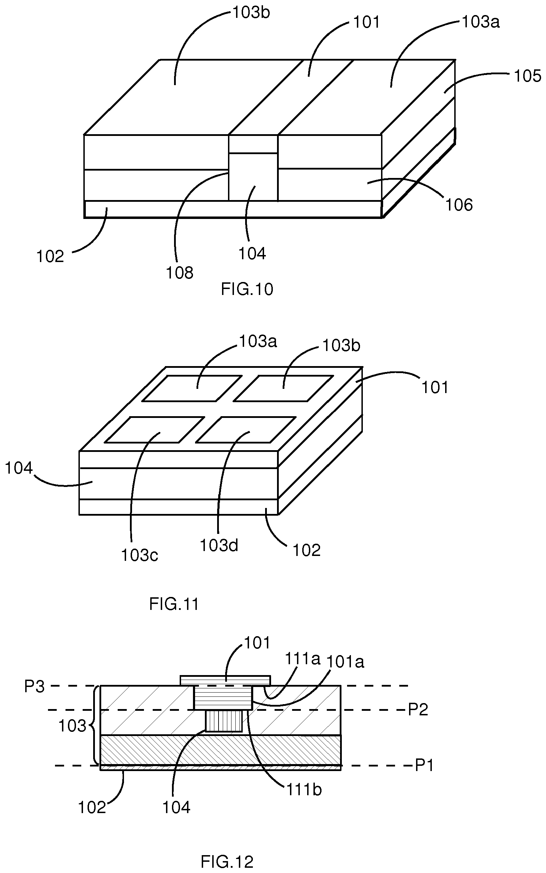

Selon une mise en oeuvre particulière, illustrée à la figure 10, la structure comporte au moins deux empilements 103a, 103b distincts s'étendant de la deuxième électrode 102. L'élément diélectrique 104 s'étend de la deuxième électrode 102 entre les empilements 103a, 103b et est en contact avec une partie, délimitée au moins par les premier et deuxième éléments semi-conducteurs 105, 106, d'une paroi latérale 108 de chacun des empilements. Par ailleurs, la première électrode 101 s'étend de l'élément diélectrique 104 au moins en partie entre les deux empilements 103a, 103b, ladite première électrode 101 étant en contact avec une autre partie, délimitée par le premier élément semi-conducteur 105, de la paroi latérale de chacun des empilements 103a, 103b. Dans cette configuration particulière, la structure présente un meilleure rendement du fait d'une plus grande surface de contact de la première électrode avec les empilements et du fait que les empilements sont ainsi moins susceptibles d'avoir subi de dislocations lors de leur formation (notamment lorsqu'il s'agit de croissance en îlots).

Selon un perfectionnement de la mise en oeuvre de la figure 10, la structure peut comporter (figure 11) une pluralité d'empilements distincts 103a, 103b, 103c, 103d s'étendant de la deuxième électrode commune à tous les empilements. Chaque empilement forme alors un îlot isolé. L'élément diélectrique 104 s'étend aussi de la deuxième électrode 102 de manière à être en contact avec tous les empilements 103a, 103b, 103c, 103d. Par ailleurs, la première électrode 101 s'étend de l'élément diélectrique 104 de manière à être en contact avec tous les empilements de la structure, ladite première électrode 101 permettant alors l'injection de porteurs dans chacun des empilements 103a, 103b, 103c, 103d.

Selon un exemple illustrée à la figure 12, la première électrode 101 comporte au moins deux faces additionnelles 111a, 111b d'injection de porteurs dans l'empilement chacune incluses dans les plans décalés P2, P3 et sensiblement parallèles au plan P1 incluant la deuxième électrode (en particulier incluant la deuxième face d'injection), de préférence une des faces additionnelles 111a est en contact avec une extrémité de l'empilement 103 opposée à la deuxième électrode 102 et est relié à l'autre face additionnelle 111b par l'intermédiaire de la première face d'injection 101a. On comprend alors qu'une partie de ladite autre face additionnelle est en contact avec l'élément diélectrique 104. Autrement dit, la première électrode 101 peut comporter une section, dans un plan parallèle à la direction selon laquelle l'empilement est formé, dont le profil délimite un épaulement destiné à recouvrir en partie l'extrémité de l'empilement opposé à la deuxième électrode.

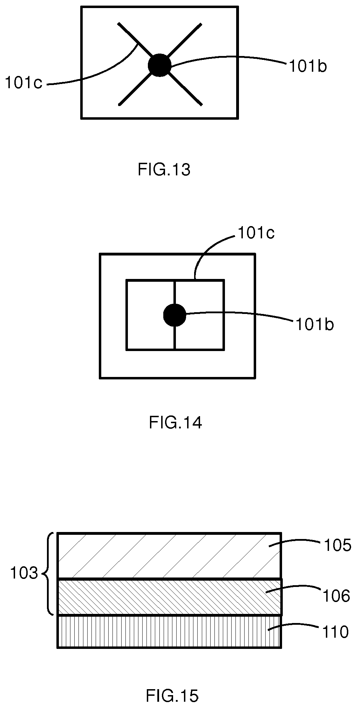

Selon une mise en oeuvre particulière, la surface de contact entre la première électrode 101 et le premier élément semi-conducteur 105 peut être augmentée par un recouvrement d'une partie de la face du premier élément semi-conducteur 105 opposée à la deuxième électrode 102 (et formant notamment la face d'émission de la structure) par une partie de la première électrode 101 pour laquelle l'élément diélectrique 104 n'est pas interposé entre ladite partie de la première électrode 101 et la deuxième électrode 102. Ceci permet d'accroitre la surface de contact entre la première électrode 101 et le premier élément semi-conducteur 105 de manière à réduire la résistance de contact. Bien entendu, cette partie de la première électrode non associée à l'élément diélectrique est adaptée en forme et en dimension de sorte à présenter un bon compromis quant à l'efficacité du rayonnement électromagnétique émis par la structure et à la résistance de contact mentionnée ci-dessus. Les figures 13 et 14 illustrent de tels exemples où seule la partie centrale 101b est située à la vertical de l'élément diélectrique, des bras 101c s'étendant le long de la face d'émission de la structure à partir de la partie centrale 101b.

Un dispositif émissif, notamment pour affichage ou pour éclairage, peut comprendre au moins une structure telle que décrite, et avantageusement un élément d'alimentation électrique de chaque structure en vue d'émettre un rayonnement électromagnétique correspondant.

En fait, chaque structure forme alors une, ou plusieurs, diodes électroluminescentes.

Par ailleurs, l'invention est aussi relative à un procédé de fabrication d'une structure telle que décrite. Un tel procédé de fabrication de la structure comporte ainsi avantageusement une étape de formation, notamment par croissance et de préférence à partir d'un substrat de support, de l'empilement 103 et une étape de formation, notamment par dépôt, de la première électrode 101. On comprend alors que la première électrode 101 comporte consécutivement à sa formation au moins une première face d'injection 101a de porteurs orientée dans une direction différente de la direction dans laquelle l'empilement 103 est formé (figures 3 à 5 et 7 à 12).

Typiquement, la croissance de l'empilement est réalisée lorsque ce dernier comprend les matériaux visés ci-avant. Avantageusement l'empilement comprend successivement à partir d'un substrat en saphir, une couche en GaN tampon, une couche en GaN dopée N, une couche de puits d'InGaN, une couche en GaN dopé P. Par ailleurs, le procédé peut aussi comporter une étape de formation de la deuxième électrode 102 telle que décrite, et une étape de formation d'un élément diélectrique tel que décrit.

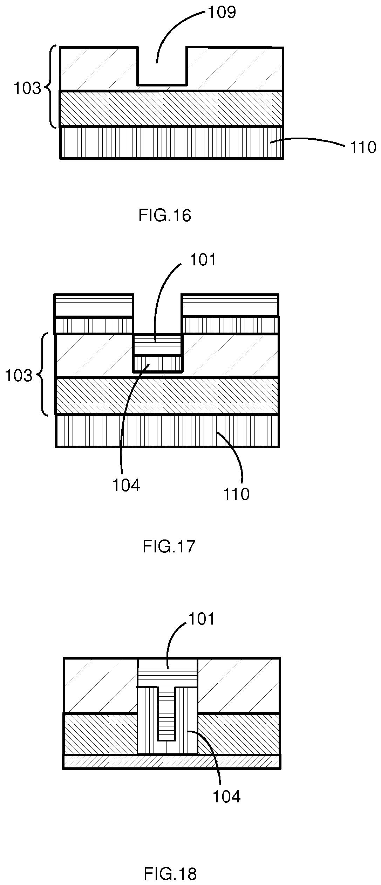

L'étape de formation de l'empilement 103 peut comporter, comme illustré à la figure 15 la formation, notamment par croissance, du premier élément semi-conducteur 105 et du deuxième élément semi-conducteur 106 destiné à être interposé entre le premier élément semi-conducteur 105 et la deuxième électrode 102. En outre, le procédé peut comporter une étape de gravure (figures 16 et 17) d'au moins le premier élément semi-conducteur 105 en direction du deuxième élément semi-conducteur 106 et une étape de formation, notamment par dépôt, de l'élément diélectrique 104 dans au moins une partie de l'ouverture 109 créée par l'étape de gravure, l'étape de formation de la première électrode 101 étant réalisée par formation de ladite première électrode 101 sur l'élément diélectrique 104, ladite première électrode 101 occupant au moins une partie du reste de l'ouverture. Selon cette réalisation, l'étape de gravure d'au moins le premier élément semi-conducteur utilise un masque adapté, après dépôt d'une couche destinée à former l'élément diélectrique 104 et d'une couche destinée à former de la première électrode 101, ce même masque (on peut utiliser un masque inversé ou une résine négative) adapté peut être réutilisé pour graver lesdites couches afin de délimiter l'élément diélectrique final et la première électrode finale. Par ailleurs, du fait de la présence de la première face d'injection de la première électrode, on comprend que l'épaisseur de diélectrique déposé est inférieure à la profondeur de l'ouverture obtenue lors de la gravure. La profondeur de la gravure pourra être adaptée pour obtenir toutes les configurations de l'élément diélectrique telles que décrites ci-avant.

Avantageusement, pour des raisons facilitant les étapes technologiques et notamment pour éviter des incompatibilités de croissance de l'empilement à partir d'un support ayant des incompatibilités cristallographiques, l'empilement sera formé avant la formation des première et deuxième électrodes. Ainsi, comme évoqué précédemment, le procédé peut comporter une étape de fourniture d'un substrat 109 de support présentant une surface de propriétés cristallographiques (comme l'orientation cristallographique et/ou le paramètre de maille) adaptée à la croissance de l'empilement 103 (figures 15 à 17).

Ensuite, selon une première réalisation mettant en oeuvre le substrat de support adapté, et notamment dans le cas où le deuxième élément semi-conducteur est en contact avec le substrat de support 110 (figures 15 à 17), l'étape de gravure dans au moins le premier élément semi-conducteur 105 est réalisée au niveau du sommet de l'empilement 103 à l'opposé du substrat de support 110. Une fois ceci réalisé, le substrat de support 110 pourra être supprimé de sorte à laisser libre la face du deuxième élément semi-conducteur 106 initialement en contact avec le substrat de support 110 et la deuxième électrode sera déposée de préférence sur toute cette face du deuxième élément semi-conducteur 106 initialement en contact avec le substrat de support 110.

Selon une deuxième réalisation (non représentée), mettant en oeuvre le substrat de support, et notamment dans le cas où le premier élément semi-conducteur est en contact avec le substrat de support, la deuxième électrode sera formée sur le sommet de l'empilement opposé au substrat de support. Par ailleurs, le substrat de support pourra être supprimé de sorte à laisser libre la face du premier élément semi-conducteur initialement en contact avec le substrat de support, et l'étape de gravure pourra alors être réalisée avant de former dans l'ouverture obtenue par la gravure l'élément diélectrique puis la première électrode.

Selon une alternative associée à la structure à plusieurs empilements distincts, le procédé de fabrication peut comporter les étapes suivantes : la formation d'au moins deux empilements distincts, notamment à partir d'un substrat de support de structure cristallographique adaptée, chacun muni d'un premier élément semi-conducteur et d'un deuxième élément semi-conducteur ; la formation d'un élément diélectrique dans un espace libre séparant les empilements, notamment par dépôt conforme dudit élément diélectrique ; la formation de la première électrode de sorte à ce qu'elle soit en contact avec l'élément diélectrique et avec une partie de la paroi latérale des empilements formée par les premier éléments semi-conducteurs desdits empilements. Cette alternative est d'autant plus pertinente dans le cadre où l'empilement est obtenu par croissance de semi-conducteurs lll-V ou II-VI. En effet, ces semi-conducteurs requièrent à minima une cohérence entre le paramètre de maille du semi-conducteur correspondant et celui du substrat sur lequel la croissance dudit semi-conducteur a lieu. Dans le cas d'incohérence trop forte des paramètres de maille, le semi-conducteur devra relaxer des contraintes compressives ou extensives, sans quoi il se formera des dislocations dans le cristal semi-conducteur. Ces dislocations induisent des défauts profonds dans le gap du semi-conducteur qui limitent ses performances électro-optiques. Autrement dit, la formation d'empilements distincts et de dimensions réduites permet de limiter les contraintes afin de limiter la formation de dislocations.

De préférence, comme évoqué ci-dessus le substrat de support présente une structure cristallographique adaptée aux matériaux que l'on souhaite faire croître dessus. La principale caractéristique de ce substrat peut être le désaccord de paramètre de maille (il faut qu'il soit le plus faible possible).

Selon une mise en oeuvre particulière du procédé de fabrication associé à l'alternative donnée ci-dessus et illustrée à la figure 18, l'élément diélectrique 104 couvre la paroi latérale de deux empilements adjacents par un dépôt conforme, et l'espace restant disponible est comblé avec la première électrode 101. Cette variante offre l'avantage de réaliser une première électrode 101 avec un facteur de forme important en conservant pour autant une faible résistance électrique (en conséquence peu de perte ohmique dans la distribution du courant dans la structure). Autrement dit, de manière générale, la première électrode 101 peut être conformée de sorte à pénétrer ledit élément diélectrique 104. Il est aussi possible d'envisager que l'électrode 101 aille jusqu'en face arrière de l'empilement semi-conducteur. Dans cette configuration, l'électrode formée en face arrière sera structurée de manière à ce que les contacts des deux électrodes de la diode électroluminescente soient en face arrière de la diode électroluminescente et pourtant isolé l'un de l'autre.

Le procédé de fabrication peut comporter toutes les étapes souhaitées et configurées de sorte à réaliser tout ou partie de la structure.

Il a été décrit ci-avant un procédé de fabrication d'une structure telle que décrite. Il va de soi qu'un procédé de fabrication du dispositif tel que décrit peut comporter au moins une étape de mise en oeuvre du procédé de fabrication de la structure.

## Revendications

1. Structure (100) destinée à émettre un rayonnement électromagnétique, comportant des première et deuxième électrodes (101, 102) configurées de sorte à permettre l'injection de porteurs dans au moins un empilement (103) à base de semi-conducteurs en vue de leurs recombinaisons dans une zone active de l'empilement (103) pour former tout ou partie du rayonnement électromagnétique à émettre, la première électrode (101) présentant au moins une première face d'injection (101a) de porteurs dans l'empilement (103) orientée dans une direction différente de la direction dans laquelle l'empilement (103) est formé, et la deuxième électrode (102) comportant une deuxième face d'injection (102a) de porteurs dans l'empilement (103), **caractérisée en ce que** ladite deuxième face d'injection (102a) comporte une première portion (102b) en regard de la première électrode (101) et une deuxième portion (102c) pour laquelle la première électrode (101) n'est pas en regard, et **en ce qu'**un élément diélectrique (104), en contact avec la première électrode (101), est interposé entre au moins une partie de la première électrode (101) et au moins une partie de la première portion (102b).

2. Structure selon la revendication 1, **caractérisée en ce que** l'empilement (103) comporte un premier élément semi-conducteur (105) présentant un premier dopage et un deuxième élément semi-conducteur (106) présentant un deuxième dopage de conductivité opposée au premier dopage, et **en ce que** la première face d'injection (101a) est configurée de sorte à injecter des porteurs d'un premier type dans le premier élément semi-conducteur (105), et la deuxième électrode (102) est configurée de sorte à injecter des porteurs d'un second type dans le deuxième élément semi-conducteur (106).

3. Structure selon la revendication précédente, **caractérisée en ce que** le premier élément semi-conducteur est dopé n.

4. Structure selon la revendication 2 ou la revendication 3, **caractérisée en ce que** l'élément diélectrique (104) est en contact avec :
- la première électrode (101) et le premier élément semi-conducteur (105), ou
- la première électrode (101), le premier élément semi-conducteur (105) et le deuxième élément semi-conducteur (106), ou
- la première électrode (101), le premier élément semi-conducteur (105), le deuxième élément semi-conducteur (106) et la deuxième électrode (102).

5. Structure selon l'une quelconque des revendications 2 à 4, **caractérisée en ce qu'**au moins une portion de la première électrode (101) s'étendant à partir de l'élément diélectrique (104) dans une direction opposée à la deuxième électrode (102) est entourée par, et est en contact avec, le premier élément semi-conducteur (105).

6. Structure selon l'une quelconque des revendications 2 à 5, **caractérisée en ce qu'**elle comporte au moins deux empilements (103a, 103b) distincts s'étendant de la deuxième électrode (102), et **en ce que** :
- l'élément diélectrique (104) s'étend de la deuxième électrode (102) entre les empilements, et est en contact avec une partie, délimitée au moins par les premier et deuxième éléments semi-conducteurs (105,106), d'une paroi latérale de chacun des empilements,
- la première électrode (101) s'étend de l'élément diélectrique (104) au moins en partie entre les deux empilements (103a, 103b), ladite première électrode (101) étant en contact avec une autre partie, délimitée par le premier élément semi-conducteur (105), de la paroi latérale de chacun des empilements (103a, 103b).

7. Structure selon l'une quelconque des revendications précédentes, **caractérisée en ce que** la première électrode (101) comporte au moins deux faces additionnelles (111a, 111b) d'injection de porteurs dans l'empilement (103) chacune incluses dans les plans décalés et sensiblement parallèles au plan incluant la deuxième électrode (102), de préférence une des faces additionnelles est en contact avec une extrémité de l'empilement opposée à la deuxième électrode (102), et est relié à l'autre face additionnelle (111b) par l'intermédiaire de la première face d'injection (101a).

8. Dispositif émissif, notamment pour affichage ou pour éclairage, comprenant au moins une structure selon l'une quelconque des revendications précédentes.

9. Procédé de fabrication d'une structure selon l'une quelconque des revendications 1 à 7, comportant :
- une étape de formation, notamment par croissance, de l'empilement (103),
- une étape de formation, notamment par dépôt, de la première électrode
**caractérisé en ce qu'**il comporte,
- une étape de formation de la deuxième électrode (102) de telle sorte qu'elle comporte une deuxième face d'injection (102a) de porteurs dans l'empilement (103), ladite deuxième face d'injection (102a) comportant une première portion (102b) en regard de la première électrode (101) et une deuxième portion (102c) pour laquelle la première électrode (101) n'est pas en regard,
et **en ce qu'**un élément diélectrique (104), en contact avec la première électrode (101), est interposé entre au moins une partie de la première électrode (101) et au moins une partie de la première portion (102b).

10. Procédé selon la revendication précédente, **caractérisé en ce que** l'étape de formation de l'empilement (103) comporte la formation d'un premier élément semi-conducteur (105) et d'un deuxième élément semi-conducteur (106) destiné à être interposé entre le premier élément semi-conducteur (105) et la deuxième électrode (102).

11. Procédé selon la revendication précédente, **caractérisé en ce qu'**il comporte une étape de gravure d'au moins le premier élément semi-conducteur (105) en direction du deuxième élément semi-conducteur (106) et **en ce qu'**il comporte une étape de formation, notamment par dépôt, de l'élément diélectrique (104) dans au moins une partie de l'ouverture créée par l'étape de gravure, l'étape de formation de la première électrode (101) étant réalisée par formation de ladite première électrode (101) sur l'élément diélectrique (104), ladite première électrode (101) occupant au moins une partie du reste de l'ouverture.

12. Procédé selon l'une des revendications 9 à 11, **caractérisé en ce qu'**il comporte les étapes suivantes :
- la formation d'au moins deux empilements distincts (103a, 103b) chacun muni d'un premier élément semi-conducteur (105) et d'un deuxième élément semi-conducteur (106), notamment à partir d'un substrat de support de cristallographie adaptée à la formation par croissance des empilements,
- la formation de l'élément diélectrique dans un espace libre séparant les empilements, notamment par dépôt conforme dudit élément diélectrique,
- la formation de la première électrode de sorte à ce qu'elle soit en contact avec l'élément diélectrique et avec une partie de la paroi latérale des empilements formée par les premiers éléments semi-conducteurs desdits empilements.

## Patentansprüche

1. Struktur (100), die dazu bestimmt ist, eine elektromagnetische Strahlung abzugeben, die eine erste und eine zweite Elektrode (101, 102) umfasst, die derart konfiguriert sind, dass das Einspritzen von Trägerstoffen in mindestens eine Stapelung (103) auf Basis von Halbleitern zu ihrer Rekombination in einer aktiven Zone der Stapelung (103) erlaubt wird, um die gesamte oder einen Teil der abzugebenden elektromagnetischen Strahlung zu bilden, wobei die erste Elektrode (101) mindestens eine erste Einspritzfläche (101a) von Trägerstoffen in die Stapelung (103) aufweist, die in eine Richtung ausgerichtet ist, die von der Richtung unterschiedlich ist, in der die Stapelung (103) gebildet ist, und die zweite Elektrode (102) eine zweite Einspritzfläche (102a) von Trägerstoffen in die Stapelung (103) umfasst, **dadurch gekennzeichnet, dass** die zweite Einspritzfläche (102a) einen ersten Abschnitt (102b) gegenüber der ersten Elektrode (101) umfasst, und einen zweiten Abschnitt (102c), für den die erste Elektrode (101) nicht gegenüber liegt, und dass ein dielektrisches Element (104) in Berührung mit der ersten Elektrode (101) zwischen mindestens einen Teil der ersten Elektrode (101) und mindestens einen Teil des ersten Abschnitts (102b) eingefügt ist.

2. Struktur nach Anspruch 1, **dadurch gekennzeichnet, dass** die Stapelung (103) ein erstes Halbleiterelement (105) umfasst, das eine erste Dotierung aufweist, und ein zweites Halbleiterelement (106), das eine zweite Dotierung mit Leitfähigkeit entgegengesetzt zu der ersten Dotierung aufweist, und dass die erste Einspritzfläche (101a) derart konfiguriert ist, dass Trägerstoffe eines ersten Typs in das erste Halbleiterelement (105) eingespritzt werden, und die zweite Elektrode (102) derart konfiguriert ist, dass Trägerstoffe eines zweiten Typs in das zweite Halbleiterelement (106) eingespritzt werden.

3. Struktur nach dem vorhergehenden Anspruch, **dadurch gekennzeichnet, dass** das erste Halbleiterelement n-dotiert ist.

4. Struktur nach Anspruch 2 oder Anspruch 3, **dadurch gekennzeichnet, dass** das dielektrische Element (104) in Berührung ist mit:
- der ersten Elektrode (101) und dem ersten Halbleiterelement (105), oder
- der ersten Elektrode (101), dem ersten Halbleiterelement (105) und dem zweiten Halbleiterelement (106), oder
- der ersten Elektrode (101), dem ersten Halbleiterelement (105), dem zweiten Halbleiterelement (106) und der zweiten Elektrode (102) .

5. Struktur nach einem der Ansprüche 2 bis 4, **dadurch gekennzeichnet, dass** sich mindestens ein Abschnitt der ersten Elektrode (101), der sich ausgehend von dem dielektrischen Element (104) in eine Richtung entgegengesetzt zu der zweiten Elektrode (102) erstreckt, von dem ersten Halbleiterelement (105) umgeben und mit ihm in Berührung ist.

6. Struktur nach einem der Ansprüche 2 bis 5, **dadurch gekennzeichnet, dass** sie mindestens zwei getrennte Stapelungen (103a, 103b) umfasst, die sich von der zweiten Elektrode (102) erstrecken, und dass:
- sich das dielektrische Element (104) von der zweiten Elektrode (102) zwischen den Stapelungen erstreckt und mit einem Teil, der von mindestens dem ersten und zweiten Halbleiterelement (105, 106) abgegrenzt ist, einer Seitenwand jeder der Stapelungen in Berührung ist,
- sich die erste Elektrode (101) von dem dielektrischen Element (104) mindestens zum Teil zwischen den zwei Stapelungen (103a, 103b) erstreckt, wobei die erste Elektrode (101) mit einem anderen Teil in Berührung ist, der von dem ersten Halbleiterelement (105) der Seitenwand jeder der Stapelungen (103a, 103b) abgegrenzt ist.

7. Struktur nach einem der vorhergehenden Ansprüche, **dadurch gekennzeichnet, dass** die erste Elektrode (101) mindestens zwei zusätzliche Flächen (111a, 111b) zum Einspritzen von Trägerstoffen in die Stapelung (103) umfasst, die jede in den versetzten und im Wesentlichen zu der Ebene, die die zweite Elektrode (102) enthält, parallelen Ebenen enthalten sind, wobei bevorzugt eine der zusätzlichen Flächen mit einem Ende der Stapelung der zweiten Elektrode (102) entgegengesetzt in Berührung ist und mit der anderen zusätzlichen Fläche (111b) über die erste Einspritzfläche (101a) in Berührung ist.

8. Emissionsvorrichtung insbesondere zum Anzeigen oder zur Beleuchtung, die mindestens eine Struktur nach einem der vorhergehenden Ansprüche umfasst.

9. Verfahren zur Herstellung einer Struktur nach einem der Ansprüche 1 bis 7, das Folgendes umfasst:
- einen Schritt des Bildens, insbesondere durch Aufwachsen, der Stapelung (103),
- einen Schritt des Bildens, insbesondere durch Abscheidung, der ersten Elektrode
**dadurch gekennzeichnet, dass** es Folgendes umfasst,
- einen Schritt des Bildens der zweiten Elektrode (102) derart, dass sie eine zweite Einspritzfläche (102a) von Trägerstoffen in die Stapelung (103) umfasst, wobei die zweite Einspritzfläche (102a) einen ersten Abschnitt (102b) gegenüber der ersten Elektrode (101) und einen zweiten Abschnitt (102c), für den die erste Elektrode (101) nicht gegenüber liegt, umfasst,
und dass ein dielektrisches Element (104) in Berührung mit der ersten Elektrode (101) zwischen mindestens einen Teil der ersten Elektrode (101) und mindestens einen Teil des zweiten Abschnitts (102b) eingefügt ist.

10. Verfahren nach dem vorhergehenden Anspruch, **dadurch gekennzeichnet, dass** der Schritt des Bildens der Stapelung (103) das Bilden eines ersten Halbleiterelements (105) und eines zweiten Halbleiterelements (106) umfasst, das dazu bestimmt ist, zwischen das erste Halbleiterelement (105) und das zweite Halbleiterelement (102) eingefügt zu sein.

11. Verfahren nach dem vorhergehenden Anspruch, **dadurch gekennzeichnet, dass** es einen Schritt des Ätzens mindestens eines ersten Halbleiterelements (105) in Richtung des zweiten Halbleiterelements (106) umfasst, und dass es einen Schritt des Bildens, insbesondere durch Abscheidung, des dielektrischen Elements (104) in mindestens einem Teil der Öffnung umfasst, die von dem Ätzschritt geschaffen wird, wobei der Bildungsschritt der ersten Elektrode (101) durch Bilden der ersten Elektrode (101) auf dem dielektrischen Element (104) ausgeführt wird, wobei die erste Elektrode (101) mindestens einen Teil des Rests der Öffnung belegt.

12. Verfahren nach einem der Ansprüche 9 bis 11, **dadurch gekennzeichnet, dass** es die folgenden Schritte umfasst:
- die Bildung von mindestens zwei verschiedenen Stapelungen (103a, 103b), wobei jede über ein erstes Halbleiterelement (105) und ein zweites Halbleiterelement (106) verfügt, insbesondere aus einem für die Bildung der Stapelungen durch Aufwachsen geeigneten Kristallographie-Trägersubstrat,
- die Bildung des dielektrischen Elements in einem die Stapelungen trennenden Freiraum, insbesondere durch entsprechende Abscheidung des genannten dielektrischen Elements,
- die Bildung der ersten Elektrode, derart dass diese mit dem dielektrischen Element und mit einem Teil der Seitenwand der Stapelungen in Berührung ist, die durch die ersten Halbleiter-Elemente der genannten Stapelungen gebildet ist.

## Claims

1. Structure (100) intended to emit electromagnetic radiation, comprising first and second electrodes (101,102) configured so as to allow carriers to be injected into at least one semiconductor-based stack (103) with a view to making them recombine in an active zone of the stack (103) in order to form all or some of the electromagnetic radiation to be emitted, the first electrode (101) having at least one first face (101a) for injecting carriers into the stack (103), said first face being oriented in a different direction to the direction in which the stack (103) is formed, and the second electrode (102) comprising a second face (102a) for injecting carriers into the stack (103), **characterized in that** said second injection face (102a) comprises a first portion (102b) facing the first electrode (101) and a second portion (102c) for which the first electrode (101) is not facing, and **in that** a dielectric element (104), making contact with the first electrode (101), is interposed between at least one part of the first electrode (101) and at least one part of the first portion (102b).

2. Structure according to claim 1, **characterized in that** the stack (103) comprises a first semiconductor element (105) doped with a first dopant, and a second semiconductor element (106) doped with a second dopant of opposite conductivity to the first dopant, and **in that** the first injection face (101a) is configured so as to inject carriers of a first type into the first semiconductor element (105), and the second electrode (102) is configured so as to inject carriers of a second type into the second semiconductor element (106).

3. Structure according to the preceding claim, **characterized in that** the first semiconductor element is n-doped.

4. Structure according to claim 2 or claim 3, **characterized in that** the dielectric element (104) makes contact with:
- the first electrode (101) and the first semiconductor element (105); or
- the first electrode (101), the first semiconductor element (105) and the second semiconductor element (106); or
- the first electrode (101), the first semiconductor element (105), the second semiconductor element (106) and the second electrode (102).

5. Structure according to any one of claims 2 to 4, **characterized in that** at least one portion of the first electrode (101) extending from the dielectric element (104) in a direction opposite to the second electrode (102) is encircled by and makes contact with the first semiconductor element (105).

6. Structure according to any one of claims 2 to 5, **characterized in that** it comprises at least two separate stacks (103a, 103b) extending from the second electrode (102), and **in that**:
- the dielectric element (104) extends from the second electrode (102) between the stacks, and makes contact with one part, bounded at least by the first and second semiconductor elements (105, 106), of a sidewall of each of the stacks;
- the first electrode (101) extends from the dielectric element (104) at least partially between the two stacks (103a, 103b), said first electrode (101) making contact with another part, bounded by the first semiconductor element (105), of the sidewall of each of the stacks (103a, 103b).

7. Structure according to any one of the preceding claims, **characterized in that** the first electrode (101) comprises at least two additional faces (111a, 111b) for injecting carriers into the stack (103), each additional face being contained in planes shifted from and substantially parallel to the plane containing the second electrode (102), and preferably one of the additional faces makes contact with that end of the stack which is opposite the second electrode (102), and is connected to the other additional face (111b) via the first injection face (101a).

8. Emissive device, especially a displaying or illuminating device, comprising at least one structure according to any one of the preceding claims.

9. Process for fabricating a structure according to any one of claims 1 to 7, comprising:
- a step of forming, especially by growth, the stack (103);
- a step of forming, especially by deposition, the first electrode; **characterized in that** it comprises,
- a step of forming the second electrode (102) such that it comprises a second face (102a) for injecting carriers into the stack (103), said second injection face (102a) comprising a first portion (102b) facing the first electrode (101) and a second portion (102c) for which the first electrode (101) is not facing,
and **in that** a dielectric element (104), making contact with the first electrode (101), is interposed between at least one part of the first electrode (101) and at least one part of the first portion (102b).

10. Process according to the preceding claim, **characterized in that** the step of forming the stack (103) comprises forming a first semiconductor element (105) and a second semiconductor element (106) that is intended to be interposed between the first semiconductor element (105) and the second electrode (102).

11. Process according to the preceding claim, **characterized in that** it comprises a step of etching at least the first semiconductor element (105) in the direction of the second semiconductor element (106), and **in that** it comprises a step of forming, especially by deposition, the dielectric element (104) in at least one part of the hole created by the etching step, the step of forming the first electrode (101) being carried out by forming said first electrode (101) on the dielectric element (104), said first electrode (101) occupying at least one part of the rest of the hole.

12. Process according to any one of claims 9 to 11, **characterized in that** it comprises the following steps:
- forming at least two separate stacks (103a, 103b), each stack being equipped with a first semiconductor element (105) and a second semiconductor element (106), especially on a carrier substrate having a crystal structure suitable for growth of the stacks;
- forming the dielectric element in a free space separating the stacks, especially by conformal deposition of said dielectric element;
- forming the first electrode so that it makes contact with the dielectric element and with one part of that sidewall of the stacks which is formed by the first semiconductor elements of said stacks.
